# EUROPÄISCHE PATENTSCHRIFT

(11) **EP 3 266 034 B1**
(45) Veröffentlichungstag und Bekanntmachung des Hinweises auf die Patenterteilung: **18.12.2019**
(21) Anmeldenummer: 16711110.3
(22) Anmeldetag: 25.02.2016
(51) Int. Cl.: H01J 37/08, H01J 37/317, H01J 27/02

(54) **KOMPONENTE EINES IONENIMPLANTERS**
COMPONENT OF AN ION IMPLANTER
COMPOSANTE D'UN IMPLANTEUR D'IONS

(30) Priorität: 02.03.2015 AT 612015 U
(43) Veröffentlichungstag der Anmeldung: 10.01.2018
(73) Patentinhaber: Plansee SE, 6600 Reutte (AT)
(72) Erfinder: WERNINGHAUS, Thomas, 08324 Bockau (DE); MAYR-SCHMÖLZER, Bernhard, 6600 Reutte (AT); KATHREIN, Martin, 6531 Ried (AT)
(74) Vertreter: Ciesla, Bettina
(86) Internationale Anmeldenummer: PCT/AT2016/000016
(87) Internationale Veröffentlichungsnummer: WO 2016/138547

(56) Entgegenhaltungen:
- JP-A- H01 255 140
- US-A- 4 946 706
- US-A- 5 857 889
- "Tungsten - Werkstoffeigenschaften und Anwendungen Material properties and applications", INTERNET CITATION, 8. April 2009 (2009-04-08), Seiten 1-36, XP007908144, Gefunden im Internet: URL:http://www.plansee.com/lib/Tungsten_DE .pdf [gefunden am 2009-04-08]
- "Molybdän Molybdenum - Werkstoffeigenschaften und Anwendungen Material properties and applications", INTERNET CITATION, 8. April 2009 (2009-04-08), Seiten 1-32, XP007908145, Gefunden im Internet: URL:http://www.plansee.com/lib/Molybdenum_ 530DE.pdf [gefunden am 2009-04-08]

## Beschreibung

Die Erfindung betrifft einen lonenimplanter, der zumindest eine Komponente, gefertigt aus einem Refraktärmetall (RM), ausgewählt aus der Gruppe bestehend aus Wolfram (W), W-Legierung, Molybdän (Mo) und Mo-Legierung, umfasst. Des Weiteren betrifft die Erfindung eine RM-Komponente.

lonenimplanter werden beispielsweise bei der Herstellung von Halbleiterbauteilen, Flachbildschirmen und Solarzellen verwendet. Darüber hinaus sind Anwendungen in der Bearbeitung und Oberflächenmodifikation von Werkstoffen zu finden. Im lonenimplanter wird mit Hilfe einer lonenquelle ein lonenstrahl erzeugt. Dieser lonenstrahl wird in einem Strahlengang auf einen Halbleiterwafer gelenkt, wodurch der Wafer dotiert und dadurch in seinen elektrischen, kristallinen und/oder strukturellen Eigenschaften verändert wird. Die Komponenten des lonenimplanters sind in der lonenquelle durch das Plasma einer chemischen und mechanischen Erosion und einer hohen thermischen Belastung ausgesetzt. Diese Belastungen treten auch bei den Komponenten im Strahlengang auf. Als Strahlengang wird die gesamte Strecke von der Quelle bis zum Wafer oder Substrat bezeichnet.

lonenimplanter weisen mehrere Komponenten auf, die der Strahlerzeugung, der Strahlformung, der Strahlführung und zur Einhausung des Plasmas und dem Schutz der Anlage vor dem Plasma und/oder lonenstrahl dienen. Die lonenquelle umfasst typischerweise eine Kammer (Englisch: chamber), in der ein Plasma, welches Ionen der gewünschten Spezies enthält, erzeugt wird. Diese Spezies können sowohl Atome als auch Moleküle sein und werden dem Plasma typischerweise als Gas zugeführt. Das zur Erzeugung des Plasmas verwendete Filament wird direkt durch das Plasma geführt oder liegt mit oder ohne Kapselung außerhalb des Plasmas.

Durch eine Blende (Englisch: arc slit), der Extraktion, werden Ionen aus der lonenquelle herausgelenkt und als lonenstrahl in Richtung der Massenselektion und von dort zum Substrat oder Wafer gelenkt. Für die Implantierung wird üblicherweise nur eine bestimmte Dotierung gewünscht. Dafür wird in der Massenselektion sowohl nach Ladung als auch Masse der Ionen gefiltert. Nur Ionen mit dem gewünschten Verhältnis aus Ladung und Masse können die Massenselektion (Englisch: mass analyzer / flight tube) passieren. Nach weiteren Komponenten zur Abbremsung und Wiederbeschleunigung sowie Elektronenduschen treffen die gewünschten Ionen auf dem Substrat oder Wafer auf, wo die Implantierung oder Materialveränderung stattfindet.

Die Komponenten des lonenimplanters können wie bereits erwähnt nach ihrer funktionellen Anwendung eingeteilt werden. Dabei unterscheidet man zwischen
(a) Komponenten der Ionen- und/oder Elektronenerzeugung;
(b) Komponenten der Strahlformung und -führung (Englisch: beam former / beam guidance);
(c) Komponenten zur Einhausung des Plasmas und dem Schutz der Anlage vor dem Plasma, beziehungsweise dem lonenstrahl (Englisch: containment / protection).

Speziell die Komponenten des lonenimplanters in der Quelle und auch die Filamente sind den belastenden Bedingungen des Plasmas ausgesetzt, während Komponenten in der Strahlformung und -führung im Wesentlichen durch den lonenstrahl belastet werden. Die Beschädigung der Teile findet durch thermische Belastung, sowie chemische und mechanische Erosion statt. Dies führt zu Materialabtrag an der Oberfläche der Teile und es kann zur Verunreinigung des Substrates oder Wafers kommen. Das abgetragene Material kann auch unerwünschte Ablagerungen außerhalb des Plasmas oder des Strahlengangs hervorrufen. Diese Ablagerungen können ebenfalls eine Verunreinigung des Substrates oder Wafers zur Folge haben.

Nach dem Stand der Technik bestehen die Komponenten im Inneren von lonenimplantern aus temperaturbeständigen Materialien wie Wolfram, Molybdän, Graphit und Silizium. Die Herausforderungen im Betrieb von lonenimplantern bestehen in der Reduktion des Verschleißes der Komponenten und der Verunreinigung des Substrates oder Wafers. Verbesserungen und Entwicklungen haben daher zum Ziel, die Verunreinigungen des Substrates oder Wafers zu reduzieren oder ganz zu eliminieren, sowie die Resistenz der Komponenten gegenüber den vorherrschenden Bedingungen zu erhöhen, um längere Betriebszeiten zu erreichen. Eine Erhöhung der Betriebszeiten senkt unter anderem auch die Betriebskosten eines lonenimplanters.

Einige Möglichkeiten, um die Lebensdauer der Komponenten zu erhöhen, wurden schon in der einschlägigen Literatur beschrieben, wobei im Wesentlichen auf die Lebensdauerverlängerung von Komponenten in der Strahlführung oder -formung fokussiert wird.

So offenbart die US 2010/0140508 A1 eine Methode zur Beschichtung von Graphitbauteilen mit Si, SiC oder DLC über Chemical Vapour Deposition (CVD). Dabei wird die Herstellung einer Schicht mit < 1 µm Dicke auf einer auswechselbaren Graphitauskleidung beschrieben.

Die US 2009/0166565 A1 beschreibt eine Komponente eines Ionenimplanters, die aus Graphit besteht und mit einer Schicht, die beständiger gegenüber Abtrag als Graphit ist, versehen ist. Dieses Graphitbauteil weist eine Öffnung auf, durch die der lonenstrahl geleitet wird, wobei die genannte Schicht aus Wolfram, Wolframkarbid, Tantalkarbid, Titankarbid oder Siliziumkarbid besteht.

Ein ähnliches Konzept verfolgt die WO 2009/053678 A1, wobei hier auf einen Graphitgrundkörper eine Wolfram- oder Tantalkarbidschicht aufgebracht wird.

In der US 2002/0069824 A1 wird ein lonenimplantationssystem beschrieben, bei dem die Lichtbogenkammer (lonenquelle) mit einer keramischen Schicht bestehend aus Bornitrid oder Aluminiumoxid ausgekleidet ist.

US 5857889 beschreibt einen Ionenimplanter, bei dem der Grundkörper aus Wolfram oder Molybdän mit Bor oder einer Borverbindung wie Wolframborid oder Bornitrid beschichtet ist.

In JP-H01-255140 wird ein lonenimplanter offenbart, bei dem ein Grundkörper aus Wolfram oder Molybdän mit einem Carbid, Borid oder Nitrid wie beispielsweise MoB₂, MoC, WB, WC beschichtet ist.

US 4946706 betrifft einen lonenimplanter mit zumindest einer Komponente aus Molybdän oder Wolfram, dessen Oberfläche in einer Stickstoffatmosphäre durch Wärmebehandlung nitriert wird.

Um die negative Wirkung von Verunreinigungen des Substrats oder Wafers zu reduzieren, können Komponenten von lonenimplantern mit dem gleichen Material wie das Substratmaterial, beispielsweise Silizium, beschichtet werden. Eine Methode dafür ist in WO 2009/008626 A1 beschrieben. Dabei wird Silizium auf die betreffenden Komponenten mittels thermischen Spritzens aufgebracht. Ablagerungen entstehen bevorzugt an Stellen in der Nähe des lonenstrahls. Nimmt die Dicke des abgelagerten Materials zu, kann es zur Ablösung größerer Teile oder Partikel kommen, die wiederum in den lonenstrahl gelangen und so zu großflächigeren Verunreinigungen auf dem Substrat oder Wafer führen können. Um die Wahrscheinlichkeit von Verunreinigungen zu reduzieren, wird regelmäßig ein Reinigungsprozess des lonenimplanters durchgeführt. Dieser Schritt stellt einen entscheidenden Kostenfaktor im Betrieb dar. Deshalb ist es von Nutzen, den erforderlichen Wartungsabstand vergrößern zu können und dadurch die Effizienz des lonenimplanters zu erhöhen.

Bei den zuvor erwähnten Lösungen, die eine auf Graphit abgeschiedene Schicht beinhalten, wird zwar die Erosionsbeständigkeit erhöht, jedoch besteht ein hohes Risiko, dass sich ganze Schichtbereiche ablösen. Dies führt ebenfalls zu einer Verunreinigung des Substrats oder Wafers.

Aufgabe der Erfindung ist daher, eine Lösung bereitzustellen, wodurch die zuvor geschilderten Nachteile vermieden werden können. Insbesondere ist es Aufgabe der Erfindung eine Lösung bereitzustellen, bei der die Komponenten des lonenimplanters eine höhere Resistenz gegenüber den erwähnten Belastungen aufweisen und dadurch die Einsatzdauer der Komponenten und damit des lonenimplanters erhöht wird. Insbesondere soll die vorliegende Erfindung den Materialabtrag von Komponenten in lonenimplantern reduzieren, wodurch sowohl die Bildung von Ablagerungen, als auch die Kontamination durch Primärpartikel vermindert wird.

Diese Aufgabe wird durch den unabhängigen Anspruch gelöst.

Bevorzugte Ausführungsformen sind in den Unteransprüchen wiedergegeben. Der lonenimplanter umfasst dabei bevorzugt Komponenten zur Strahlerzeugung, Strahlformung, Strahlführung, zur Einhausung des Plasmas und zum Schutz der Anlage vor dem Plasma, beziehungsweise dem lonenstrahl (Englisch: containment / protection). Zumindest eine Komponente ist aus einem Refraktärmetall gefertigt, wobei das Refraktärmetall ausgewählt ist aus der Gruppe, bestehend aus Wolfram (W), W-Legierung, Molybdän (Mo) und Mo-Legierung. W, W-Legierungen, Mo und Mo-Legierungen werden im nachfolgenden Text auch mit RM abgekürzt. Eine RM-Komponente ist daher eine Komponente, die aus W, einer W-Legierung, Mo oder einer Mo-Legierung gefertigt ist.

Eine Oberfläche zumindest einer RM-Komponente weist zumindest bereichsweise eine Schicht auf, die zumindest bereichsweise aus zumindest einer Verbindung zumindest eines Elements, ausgewählt aus der Gruppe, bestehend aus Kohlenstoff (C), Bor (B) und Stickstoff (N), mit zumindest einem Element, ausgewählt aus der Gruppe, bestehend aus W und Mo, gebildet ist. Die Schicht ist dabei erfindungsgemäß eine Composite-Schicht, die zumindest einen Bereich aus einem Borid und zumindest einen Bereich aus einem Karbid aufweist. Bei der erfindungsgemäßen Lösung weist sowohl der Grundkörper, als auch die Schicht ein RM auf. Als Grundkörper werden im Zusammenhang mit der Erfindung die Bereiche der Komponente, die keine / oder noch keine Schicht aufweisen, bezeichnet.

Es hat sich nun gezeigt, dass durch die erfindungsgemäße Ausführung Schichthaftungsprobleme, wie diese beim Stand der Technik zu beobachten sind, nicht auftreten. Die erfindungsgemäßen Komponenten sind weiters auch deutlich resistenter gegenüber einem breiten Feld von Einsatzbedingungen, verglichen mit unbeschichteten Komponenten aus W, W-Legierungen, Mo, Mo-Legierungen oder Graphit.

Als besonders vorteilhafte Verbindungen sind die Karbide, Boride und Nitride zu erwähnen. Es eignen sich jedoch auch ausgezeichnet Verbindungen, die neben W und/oder Mo zumindest zwei Elemente der Gruppe, bestehend aus C, B und N enthalten. So konnten mit erfindungsgemäßen Verbindungen, die sowohl C als auch B enthalten, ausgezeichnete Standzeitergebnisse erzielt werden.

Die Phasenbestimmung erfolgt dabei mittels EBSD (Electron Backscatter Diffraction) und Beugungsanalyse sowie Elementabklärung mittels WDX (wellenlängendispersive Röntgenspektroskopie). Durch EBSD lässt sich ortsaufgelöst die kristallographische Struktur und die wahrscheinlichste Orientierung der einzelnen Kristallite bestimmen lässt. Dafür kommt ein, mit einem EBSD-Detektor ausgestattetes Rasterelektronenmikroskop zur Anwendung. Die Probe wird unter einem Winkel von 70° eingebaut und mit dem Primärelektronenstrahl angestrahlt. Durch Beugung eines Teils der Elektronen an der Probe ergibt sich ein so genanntes Beugungsmuster oder Beugungsbild (Englisch: diffraction pattern). Diese Beugungsbilder können über Datenbanken mit kristallographischen Daten abgeglichen werden. So kann für jeden Messpunkt auf der Probe die kristallographische Phase und die wahrscheinlichste Orientierung ermittelt werden.

Die Messung wurde unter folgenden Bedingungen durchgeführt:
- 120 µm Elektronenstrahlblende
- Hochstrommodus, 20kV Beschleunigungsspannung
- Scanfläche 57 x 24 µm²
- Vergrößerung 1.500x
- Schrittweite 0,05 µm
- Binning 4x4
- Kamera-Gain 17,06
- Kamera-Exposure 4,50
- Untergrundkorrektur: Statischer Untergrundabzug kombiniert mit normalisiertem Intensitätshistogramm
- System: FEG-REM Zeiss Ultra plus 55 mit EDAX Trident XM4 Analytik Paket, Hikari-EBSD Kamera

Die kristallographischen Daten wurden aus dem Pauling File entnommen und können folgendermaßen referenziert werden:
- W₂C: T. Epicier et al., Acta Met. 36(1988), 1903-1921
- WC: A. D. Krawitz et al., J. Am. Ceram. Soc., 72(1989), 515-517
- W₂B: E.E. Havinga et al., J. Less-Common Met., 27(1972), 169-186
- WB: Lundström T., Ark. Kemi, 30(1969), 115-127

In bevorzugter Weise weist die Schicht als RM jenes Element auf, das auch mehrheitlich den Grundkörper bildet. So ist es vorteilhaft, wenn beispielsweise der Grundkörper aus Wolfram gefertigt ist, dass auch die Schicht durch eine Verbindung des Wolframs gebildet ist. So konnten beispielsweise ausgezeichnete Ergebnisse erzielt werden, wenn der Grundkörper der Komponente aus W gefertigt ist und die Schicht W₂B, WB, WC, W₂C, W₂N oder WN umfasst.

Besonders vorteilhaft ist es, wenn bei der Herstellung der Schicht die Verbindungsbildung durch Reaktion von C und B, optional auch N mit dem W und/oder Mo des Grundkörpers erfolgt, da dadurch eine ausgezeichnete Schichthaftung erzielt werden kann.

Die Schicht kann den Grundkörper vollständig bedecken oder kann auch nur an Stellen höchster Beanspruchung aufgebracht sein. Zudem kann die Schicht ein- oder mehrlagig und/oder aus gemischten Phasen mit variierender Zusammensetzung ausgeführt sein. Wird als Grundkörper für die Komponente eine Mo-W-Legierung verwendet, was eine vorteilhafte Ausführungsform darstellt, so kann die Verbindung als metallische Bestandteile Mo und W aufweisen. In der Liste der nachfolgend angeführten vorteilhaften Boriden, Karbiden und Nitriden kann daher, ohne dass die Eigenschaften nachteilig beeinflusst werden, W teilweise durch Mo bzw. Mo teilweise durch W ersetzt sein.

Als besonders vorteilhafte binäre Verbindungen sind W₂B, WB, W₂B₅, W₁₋ₓB₃, WB₄, WC, W₂C, WN, W₂N, W₃N₂, Mo₂B, MoB, Mo₃B₂, MoB₄, MoC, Mo₂C, MoN, Mo₂N und Mo₃N₂ zu nennen. Bei besonders vorteilhaften ternären und quaternären Verbindungen ist der nichtmetallische Bestandteil der zuvor angeführten binären Verbindungen teilweise durch ein (für ternäre Verbindungen) oder zwei (für quaternäre Verbindungen) weitere(s) Element(e) aus der Gruppe C, B und N ersetzt. So ergeben sich beispielsweise für WC die ternäre Verbindungen W(C,N) und W(C,B) und als quaternäre Verbindung W(C,B,N).

Neben den jeweiligen stöchiometrischen Zusammensetzungen der Verbindung kann diese zusätzlich auch weitere Elemente, beispielsweise C, B, N, W und/oder Mo, in gelöster Form enthalten.

Erfindungsgemäß ist die Schicht eine Composite-Schicht die zumindest einen Bereich aus einem Borid von W oder Mo und zumindest einen Bereich aus einem Karbid von W oder Mo aufweist. Als Composite-Schicht ist eine Schicht zu verstehen, die aus zumindest zwei Phasenbereichen aufgebaut ist. Als besonders vorteilhafte Ausführungsform der Erfindung ist hervorzuheben, wenn die Schicht die Phasen WC und/oder W₂C enthält. Eine weitere besonders vorteilhafte Ausführungsform ist gegeben, wenn die Schicht WB und/oder W₂B enthält. Auch die Kombination von WC und/oder W₂C und WB und/oder W₂B stellt eine besonders vorteilhafte Ausgestaltung der Erfindung dar. So kann beispielsweise der äußerste Bereich der Schicht aus WC und/oder WB gebildet sein, woran ein Bereich anschließt, der W₂B- und/oder W₂C Phase aufweist. W₂B und/oder W₂C sind dabei benachbart zum Grundkörper aus W oder einer W-Legierung. In analoger Weise kann beispielsweise der äußerste Bereich der Schicht aus MoC und/oder MoB gebildet sein, woran ein Bereich anschließt, der Mo₂B- und/oder Mo₂C Phase aufweist. Mo₂B und/oder Mo₂C sind dabei benachbart zum Grundkörper aus Mo oder einer Mo-Legierung.

In einer weiteren vorteilhaften Ausgestaltungsform ist die Schicht mit dem daran anschließenden Bereich des Grundkörpers verzahnt. Dieser Verzahnungseffekt wird in einfacher Weise durch die Reaktion von C und B, optional auch N mit Mo und/oder W des Grundkörpers erzielt. Dazu werden C und B und/oder Verbindungen von C und B, optional auch N auf der Oberfläche des Grundkörpers aufgebracht. Durch Erwärmen diffundieren nun C und B, optional auch N in den Grundkörper hinein, wo es zur Verbindungsbildung kommt. Die Verzahnung wird dabei vorteilhaft durch Körner der Schicht gebildet (beispielsweise und vorteilhaft durch W₂B, W₂C, Mo₂B und/oder Mo₂C Körner). Bei Aufbringen von C und B auf Wolfram oder Molybdän bildet sich beispielsweise als oberste Schichtlage ein Karbid, das besonders beständig gegen den Angriff durch das Plasma und den lonenstrahl ist. Das Einbringen von N in die Schicht erfolgt vorzugsweise durch Glühung in einer N-haltigen Atmosphäre (Reaktionsglühung). Vorzugsweise kommen NH₃ oder eine Mischung aus zumindest zwei Gasen der Gruppe bestehend aus NH₃, H₂ und N₂ sowie Glühtemperaturen beispielsweise im Bereich 700 bis 1.300°C zum Einsatz. Die vorteilhafte mittlere Schichtdicke kann in einem weiten Bereich gewählt werden, wobei als bevorzugter Bereich 1 bis 500 µm, vorzugsweise 3 bis 100 µm zu nennen ist.

Als vorteilhafte Werkstoffe für den Grundkörper sind Rein-W, W - 0,1 bis 3 Ma% Seltenerdoxid, Rein-Mo, Mo - Titan (Ti) - Zirkon (Zr) - C (übliche Bezeichnung: TZM), Mo - Hafnium (Hf) - C (übliche Bezeichnung: MHC) oder Mo-W Legierungen zu nennen. Als besonders geeignetes Seltenerdoxid ist La₂O₃ herauszustreichen. W - La₂O₃ weist dabei ein deutlich verbessertes Zerspanungsverhalten im Vergleich zu Rein-W auf, wodurch die Herstellungskosten der Komponente deutlich reduziert werden können. Zudem ist auch die Erosionsbeständigkeit verbessert. Unter Rein-W bzw. Rein-Mo sind dabei die Metalle mit der üblichen technischen Reinheit zu verstehen.

In vorteilhafter Weise kann die erfindungsgemäße Ausführung für folgende Komponenten des lonenimplanters Verwendung finden:
- Kammer (Englisch: chamber)
- Filament (Englisch: filament)
- Filamenthalter (Englisch: filament holder)
- Blende (Englisch: arc slit),
- Endstation (Englisch: end station)
- Analysator (Englisch: analyzer)

Des Weiteren wird die Aufgabenstellung der Erfindung durch eine Komponente eines lonenimplanters erfüllt, die aus einem Refraktärmetall (RM), ausgewählt aus der Gruppe, bestehend aus W, W-Legierung, Mo und Mo-Legierung, gefertigt ist, wobei eine Oberfläche zumindest einer RM-Komponente zumindest bereichsweise eine Schicht aufweist, die zumindest bereichsweise aus einer Verbindung zumindest eines Elements, ausgewählt aus der Gruppe, bestehend aus C, B und N, mit zumindest einem Element, ausgewählt aus der Gruppe bestehend aus W und Mo, gebildet ist. Erfindungsgemäß ist die Schicht dabei eine Composite-Schicht, die zumindest einen Bereich aus einem Borid von W oder Mo und zumindest einen Bereich aus einem Karbid von W oder Mo aufweist. Bevorzugt dient die Komponente zur Strahlerzeugung, Strahlformung, Strahlführung, zur Einhausung des Plasmas und/oder dem Schutz vor dem Plasma bzw. lonenstrahl.

In vorteilhafter Weise weist die Komponente zumindest eine der nachfolgenden Eigenschaften auf:
- Die Verbindung ist aus der Gruppe a oder b gewählt, mit:
   Gruppe a: Karbide, Boride und Nitride;
   Gruppe b: Verbindung enthaltend W und/oder Mo und zumindest zwei Elemente der Gruppe, bestehend aus C, B und N.
- Die Verbindung ist aus der Gruppe, bestehend aus W₂B, WB, W₂B₅, W₁₋ₓB₃, WB₄, WC, W₂C, WN, W₂N, W₃N₂; Mo₂B, MoB, Mo₃B₂, MoB₄, MoC, Mo₂C, MoN, Mo₂N und Mo₃N₂ gewählt.
- Die äußerste Schichtlage ist durch WC oder WB zumindest teilweise gebildet.
- Die Schicht ist mit dem daran anschließenden Grundkörper verzahnt.
- Die Verzahnung ist durch Körner der Schicht gebildet.
- Die RM-Komponente weist an Stellen hoher Beanspruchung die Schicht auf.
- Zumindest eine Verbindung enthält zumindest ein Element ausgewählt aus der Gruppe bestehend aus B, C, N, W und Mo in gelöster Form.
- Die RM-Komponente ist aus Rein-W, W- 0,1 bis 3 Ma% Seltenerdoxid, Rein-Mo Mo-Ti-Zr-C (TZM), Mo-Hf-C (MHC) oder einer Mo-W-Legierung gefertigt.
- Die RM-Komponente wird als Kammer, Filament, Filamenthalter, Blende, Endstation oder Analysator eines lonenimplanters verwendet.

Ein Verfahren zur Herstellung der erfindungsgemäßen RM-Komponente weist dabei zumindest die folgenden Schritte auf:
- Herstellung der Geometrie der RM-Komponente durch übliche Verfahren;
- Aufbringen der Elemente und/oder Verbindungen der Elemente C und B, optional auch N, vorzugsweise in Pulver- oder Slurryform;
- Wärmebehandlung zur Bildung einer Verbindung mit zumindest einem RM in Vakuum, Schutzgas oder Reaktivgas.

Als übliche Verfahren zur Herstellung der RM-Komponente sind Press- / Sinterverfahren mit anschließender mechanischer Bearbeitung, Near-Net-Shape Press- / Sinterverfahren, Heißpressen, heißisostatisches Pressen, Spark-Plasma-Sintern oder Metallpulverspritzguss zu nennen. Nach Herstellung der Geometrie wird in den Bereichen, die im Einsatz die Schicht aufweisen sollen, zumindest die Elemente oder zumindest eine Verbindung der Elemente C und B, optional auch N, aufgebracht. Das Aufbringen kann beispielsweise durch Aufschütten, durch Aufpinseln, durch Tauchen oder durch Aufsprühen erfolgen. Als besonders geeignet ist das Aufbringen eines Slurrys zu erwähnen, da es hiermit auch möglich ist, Teile mit komplexen Geometrien in einfacher und vorteilhafter Weise zu beschichten. Nach dem Aufbringen von C und B und/oder mindestens einer C- und B-haltigen, optional auch einer N-haltigen Verbindung wird die Komponente in Vakuum, Schutzgas oder Reaktivgas wärmebehandelt. Als Reaktivgase eignen sich insbesondere Gase oder Gasgemische, die N (zum Beispiel NH₃ oder eine Mischung aus zumindest zwei Gasen der Gruppe bestehend aus NH₃, H₂ und N₂), C (zum Beispiel CH₄) und/oder B (zum Beispiel BH₃) enthalten. Die Temperatur liegt dabei vorteilhaft bei 700 bis 2.000°C (Glühung in Vakuum) bzw. 700 bis 1.300°C (Glühung in Reaktivgas), wobei sich der für die jeweilige Verbindung am besten geeignete Bereich durch einfache Versuche ermitteln lässt. Bei der Wärmebehandlung diffundieren / diffundiert nun C, B und/oder N in das Grundmaterial ein und bildet mit diesem die erfindungsgemäße Verbindung.

Daneben kann die Schicht auch durch andere übliche Verfahren wie beispielsweise PVD, CVD, thermische Spritzverfahren oder Glühung in Reaktivgas (zum Beispiel in den zuvor genannten Gasen / Gasmischungen) aufgebracht werden.

Im Folgenden wird die Erfindung beispielhaft näher beschrieben und mit dem Stand der Technik verglichen.
Figur 1 zeigt dabei eine einlagige Wolframkarbidschicht auf W (Probe 3) als nicht zur beanspruchten Erfindung gehörendes Vergleichsbeispiel.
Figur 2 zeigt eine erfindungsgemäße mehrlagige Composite-Schicht, die Bereiche aus Wolframkarbid und Bereiche aus Wolframborid umfasst (Probe 5).

### Beispiel

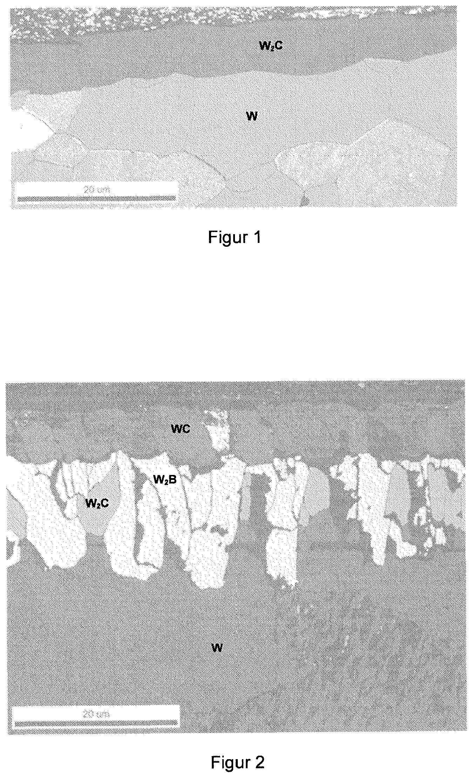

Es wurden Grundkörper aus W, W - 1 Ma% La₂O₃ (WL) und Mo durch Diffusionsprozesse mit unterschiedlichen Schichten versehen. Dazu wurde ein Slurry, der Kohlenstoff und/oder Bor enthielt, durch Tauchen auf der Oberfläche des Grundkörpers aufgebracht. Die jeweiligen C- und B-Anteile können den Tabellen 1 und 2 entnommen werden. Danach wurden die Proben einer Glühung bei 1500°C/10h in Vakuum unterzogen. Einige Proben wurden danach in einer Mischung aus NH₃ (20 Vol%), N₂ (40 Vol%) und H₂ (40 Vol%) bei 950°C / 5h geglüht. Die beteiligten Bestandteile C, B bzw. N bildeten bei der Wärmebehandlung die entsprechenden Verbindungen aus. Exemplarisch ist dies für die Proben 3 und 5 gemäß Tabelle 1 in Figur 1 und 2 wiedergeben. Die EBSD-Messung wurde wie folgt durchgeführt.
- 120 µm Elektronenstrahlblende
- Hochstrommodus, 20kV Beschleunigungsspannung
- Scanfläche 57 x 24 µm²
- Vergrößerung 1500x
- Schrittweite 0,05 µm
- Binning 4x4
- Kamera-Gain 17,06
- Kamera-Exposure 4,50
- Untergrundkorrektur: Statischer Untergrundabzug kombiniert mit normalisiertem Intensitätshistogramm
- System: FEG-REM Zeiss Ultra plus 55 mit EDAX Trident XM4 Analytik Paket, Hikari-EBSD Kamera

Die Elementabklärung erfolgte durch WDX.

Für die Probe 3 konnte nur W₂C detektiert werden (siehe Figur 1).

Probe 5 weist neben WC noch W₂C und W₂B auf (siehe Figur 2).

Die Schichtdicken variierten bei den untersuchten Proben in einem Bereich von 8 bis 40 µm. Als Referenzproben dienten die jeweiligen Werkstoffe ohne Beschichtung.

Die Proben wurden danach auf ihre Beständigkeit gegenüber einem F- bzw. F- und O-haltigen Plasma geprüft.

### Prüfbedingungen:

Frequenz des Plasmagenerators: 40 kHz
Druck: 0,3 mbar
Gas: CF₄ für F-haltiges Plasma
bzw. NF₃/O₂(NF₃: 30 Vol%, O₂: 70 Vol%) für F- und O-haltiges Plasma
Dauer: 30 Minuten

Tabelle 1 und 2 zeigen eine Übersicht der Proben und des Abtrags im Plasma. Die auf W bzw. Mo normierten Abtragwerte dokumentieren anschaulich, dass die erfindungsgemäßen Proben eine überlegene Resistenz gegenüber dem F- bzw. F- und O-haltigen Plasma aufweisen.

**Tabelle 1**

| N°. | Substratmaterial | | Atmosphäre bei Glühbehandlung | C und B Gehalt im Slurry (Bezugsgröße: C (Ma%)+ B (Ma%) =100%) | normierter Abtrag F-haltiges Plasma | normierter Abtrag F- und O-haltiges Plasma |
|---|---|---|---|---|---|---|
| 1 | W | R | - | - | 1 | 1 |
| 2 | WL | R | - | - | 0,99 | 0,80 |
| 3 | W | E | V | C:100% | 0,79 | 0,78 |
| 4 | W | E | V | C:80% / B:20% | 0,75 | 0,79 |
| 5 | W | E | V | C:50% / B:50% | 0,86 | 0,79 |
| 6 | W | E | V | C:20% / B:80% | 0,77 | 0,60 |
| 7 | WL | E | V | C:100% | | 0,62 |
| 8 | WL | E | V | C:80% / B:20% | | 0,73 |
| 9 | WL | E | V | C:50% / B:50% | | 0,67 |
| 10 | WL | E | V | C:20% / B:80% | | 0,50 |
| 11 | W | E | V+NH₃-N₂-H₂ | - | | 0,91 |
| 12 | W | E | V+NH₃-N₂-H₂ | C:100% | | 0,72 |
| 13 | W | E | V+NH₃-N₂-H₂ | C:80% / B:20% | | 0,72 |
| 14 | W | E | V+NH₃-N₂-H₂ | C:50% / B:50% | | 0,74 |
| 15 | W | E | V+NH₃-N₂-H₂ | C:20% / B:80% | | 0,67 |
| Legende: | | | | | | |
| R...Referenzprobe | | | E...Erfindungsgemäße Probe | | V...Vakuum | |

**Tabelle 2**

| N°. | Substratmaterial | | Atmosphäre bei Glühbehandlung | C und B Gehalt im Slurry (Bezugsgröße: C (Ma%)+ B(Ma%)=100%) | normierter Abtrag F-haltiges Plasma | normierter Abtrag F- und O-haltiges Plasma |
|---|---|---|---|---|---|---|
| 16 | Mo | R | - | - | 1 | 1 |
| 17 | Mo | E | V | C:100% | 0,88 | 0,84 |
| 18 | Mo | E | V | C:50% / B:50% | 0,84 | 0,77 |
| 19 | Mo | E | V | C:20% / B:80% | 0,84 | 0,76 |
| 20 | Mo | E | V+N₂-H₂ | C:50% / B:50% | | 0,75 |
| Legende: | | | | | | |
| R...Referenzprobe | | | E...Erfindungsgemäße Probe | | V...Vakuum | |

## Patentansprüche

1. Komponente eines lonenimplanters aus einem Refraktärmetall RM, ausgewählt aus der Gruppe bestehend aus Wolfram W, W-Legierung, Molybdän Mo und Mo-Legierung, wobei eine Oberfläche zumindest einer RM-Komponente zumindest bereichsweise eine Schicht aufweist, die zumindest bereichsweise aus einer Verbindung zumindest eines Elements, ausgewählt aus der Gruppe bestehend aus Kohlenstoff C, Bor B und Stickstoff N, mit zumindest einem Element, ausgewählt aus der Gruppe bestehend aus W und Mo, gebildet ist, **dadurch gekennzeichnet, dass** die Schicht als Composite-Schicht ausgeführt ist, welche zumindest einen Bereich aus einem Borid von W oder Mo und zumindest einem Bereich aus einem Karbid von W oder Mo aufweist.

2. Ionenimplanter, umfassend zumindest eine Komponente nach Anspruch 1.

3. Ionenimplanter nach Anspruch 2, **dadurch gekennzeichnet, dass** die Verbindung aus der Gruppe a oder b gewählt ist, mit:
- Gruppe a: Karbide, Boride und Nitride;
- Gruppe b: Verbindungen enthaltend W und/oder Mo und zumindest zwei Elemente der Gruppe bestehend aus C, B und N.

4. Ionenimplanter nach Anspruch 2 oder 3, **dadurch gekennzeichnet, dass** die Verbindung aus der Gruppe bestehend aus W₂B, WB, W₂B₅, W₁₋ₓB₃, WB₄, WC, W₂C, WN, W₂N, W₃N₂, Mo₂B, MoB, Mo₃B₂, MoB₄, MoC, Mo₂C, MoN, Mo₂N und Mo₃N₂ gewählt ist.

5. Ionenimplanter nach einem der Ansprüche 2-4, **dadurch gekennzeichnet, dass** WC oder WB zumindest teilweise die äußerste Schichtlage bildet.

6. Ionenimplanter nach einem der Ansprüche 2-5, **dadurch gekennzeichnet, dass** die Schicht mit dem daran anschließenden Bereich aus RM verzahnt ist.

7. Ionenimplanter nach Anspruch 6, **dadurch gekennzeichnet, dass** die Verzahnung durch Körner der Schicht gebildet ist.

8. Ionenimplanter nach einem der Ansprüche 2-7, **dadurch gekennzeichnet, dass** die RM-Komponente an Stellen hoher Beanspruchung die Schicht aufweist.

9. Ionenimplanter nach einem der Ansprüche 2-8, **dadurch gekennzeichnet, dass** zumindest eine Verbindung zumindest ein Element ausgewählt aus der Gruppe bestehend aus B, C, N, W und Mo in gelöster Form enthält.

10. Ionenimplanter nach einem der Ansprüche 2-9, **dadurch gekennzeichnet, dass** die RM-Komponente aus Rein-W, W - 0,1 bis 3 Ma% Seltenerdoxid, Rein-Mo, einer Mo - Titan (Ti) - Zirkon (Zr) - C Legierung (TZM), einer Mo - Hafnium (Hf) - C Legierung (MHC) oder einer Mo-W Legierung gefertigt ist.

11. Ionenimplanter nach einem der Ansprüche 2-10, **dadurch gekennzeichnet, dass** zumindest eine RM-Komponente, ausgewählt aus der Gruppe bestehend aus Kammer, Filament, Filamenthalter, Blende, Endstation und Analysator, zumindest bereichsweise die Schicht aufweist.

## Claims

1. Component of an Ion implanter fabricated from a refractory metal RM, selected from the group consisting of tungsten W, W alloy, molybdenum Mo and Mo alloy, wherein
a surface of at least one RM component has at least regionally a coating which is formed at least regionally of at least one compound of at least one element selected from the group consisting of carbon C, boron B and nitrogen N with at least one element selected from the group consisting of W and Mo,
**characterized in that,**
the coating is in the form of a composite coating which has at least one region of a boride of W or Mo and at least one region of a carbide of W or Mo.

2. Ion implanter comprising at least one component according to claim 1.

3. Ion implanter according to claim 2, **characterized in that** the compound is selected from the group a or b, where:
- Group a: carbides, borides and nitrides;
- Group b: compounds containing W and/or Mo and at least two elements of the group consisting of C, B and N.

4. Ion implanter according to claim 2 or 3, **characterized in that** the compound is selected from the group consisting of W₂B, WB, W₂B₅, W₁₋ₓB₃, WB₄, WC, W₂C, WN, W₂N, W₃N₂, Mo₂B, MoB, Mo₃B₂, MoB₄, MoC, Mo₂C, MoN, Mo₂N and Mo₃N₂.

5. Ion implanter according to any of the claims 2 - 4, **characterized in that** WC or WB at least partly forms the outermost coating layer.

6. Ion implanter according to any of the claims 2 - 5, **characterized in that** the coating is tooth-engaged with the adjacent region of RM.

7. Ion implanter according to claim 6, **characterized in that** the tooth-engagement is formed by grains of the coating.

8. Ion implanter according to any of the claims 2 - 7, **characterized in that** the RM component has the coating at locations of high operational demands.

9. Ion implanter according to any of the claims 2 - 8, **characterized in that** at least one compound comprises at least one element selected from the group consisting of B, C, N, W and Mo in dissolved form.

10. Ion implanter according to any of the claims 2 - 9, **characterized in that** the RM component is fabricated from pure W, W - 0.1 to 3 mass% rare earth oxide, pure Mo, a Mo-titanium (Ti)-zirconium (Zr)-C alloy (TZM), a Mohafnium (Hf)-C alloy (MHC) or a Mo-W alloy.

11. Ion implanter according to any of the claims 2 - 10, **characterized in that** at least one RM component selected from the group consisting of chamber, filament, filament holder, arc slit, end station and analyzer at least regionally has the coating.

## Revendications

1. Composant d'un implanteur d'ions composé d'un métal réfractaire RM choisi dans le groupe constitué par le tungstène W, l'alliage de W, le molybdène Mo et l'alliage de molybdène,
une surface d'au moins un composant RM présentant au moins par endroits une couche, qui au moins par endroits est formée d'au moins un composé d'au moins un élément, choisi dans le groupe constitué par le carbone C, le bore B et l'azote N, avec au moins un élément, choisi dans le groupe constitué par W et Mo,
**caractérisé en ce que**
la couche est agencée en tant que couche de composite, qui présente au moins une zone composée d'un borure de W ou de Mo et au moins une zone composée d'un carbure de W ou de Mo.

2. Implanteur d'ions, comprenant au moins un composant selon la revendication 1.

3. Implanteur d'ions selon la revendication 2, **caractérisé en ce que** le composé est choisi parmi le groupe a ou b, avec :
- groupe a : carbure, borure et nitrure ;
- groupe b : composés contenant W et/ou Mo et au moins deux éléments du groupe constitué par C, B et N.

4. Implanteur d'ions selon la revendication 2 ou 3, **caractérisé en ce que** le composé est choisi dans le groupe constitué par W₂B, WB, W₂B₅, W₁₋ₓB₃, WB₄, WC, W₂C, WN, W₂N, W₃N₂, Mo₂B, MoB, Mo₃B₂, MoB₄, MoC, Mo₂C, MoN, Mo₂N et Mo₃N₂.

5. Implanteur d'ions selon l'une quelconque des revendications 2 à 4, **caractérisé en ce que** WC ou WB forme au moins partiellement la couche en forme de feuille située le plus à l'extérieur.

6. Implanteur d'ions selon l'une quelconque des revendications 2 à 5, **caractérisé en ce que** la couche est engrenée avec la zone contigüe composée de RM.

7. Implanteur d'ions selon la revendication 6, **caractérisé en ce que** l'engrenage est formé par des grains de la couche.

8. Implanteur d'ions selon l'une quelconque des revendications 2 à 7, **caractérisé en ce que** le composant RM présente la couche à des endroits à contrainte élevée.

9. Implanteur d'ions selon l'une quelconque des revendications 2 à 8, **caractérisé en ce qu'**au moins un composé contient au moins un élément choisi dans le groupe constitué par B, C, N, W et Mo sous forme solubilisée.

10. Implanteur d'ions selon l'une quelconque des revendications 2 à 9, **caractérisé en ce que** le composant RM est fabriqué avec du W pur, du W - 0,1 à 3 % en masse d'oxyde de terres rares, du Mo pur, un alliage Mo - titane (Ti) - zirconium (Zr) - C (TZM), un alliage Mo - hafnium (Hf) - C (MHC) ou un alliage Mo-W.

11. Implanteur d'ions selon l'une quelconque des revendications 2 à 10, **caractérisé en ce qu'**au moins un composant RM, choisi dans le groupe constitué par chambre, filament, support de filament, diaphragme, station terminale et analyseur, présente au moins partiellement la couche.
